# EUROPÄISCHE PATENTSCHRIFT

(11) **EP 3 216 330 B1**
(45) Veröffentlichungstag und Bekanntmachung des Hinweises auf die Patenterteilung: **24.04.2019**
(21) Anmeldenummer: 15784030.7
(22) Anmeldetag: 21.10.2015
(51) Int. Cl.: H05K 7/20

(54) **WECHSELRICHTER UND VERFAHREN ZUM KÜHLEN EINES WECHSELRICHTERS**
INVERTER AND METHOD FOR COOLING AN INVERTER
ONDULEUR ET PROCÉDÉ DE REFROIDISSEMENT D'UN ONDULEUR

(30) Priorität: 04.11.2014 DE 102014116084
(43) Veröffentlichungstag der Anmeldung: 13.09.2017
(73) Patentinhaber: SMA Solar Technology AG, 34266 Niestetal (DE)
(72) Erfinder: FALK, Andreas, 34131 Kassel (DE); GOLDAU, Jan, 34260 Kaufungen (DE); KUEHN, Thomas, 34414 Warburg (DE); SCHNEIDER, Henning, 37235 Hessisch Lichtenau (DE); ROEMER, Jochen, 34474 Diemelstadt (DE)
(86) Internationale Anmeldenummer: PCT/EP2015/074344
(87) Internationale Veröffentlichungsnummer: WO 2016/071109

(56) Entgegenhaltungen:
- CN-A- 102 111 081
- CN-U- 203 179 659
- DE-U1-202006 008 792
- JP-A- H02 249 755

## Beschreibung

Die Erfindung betrifft einen Wechselrichter, insbesondere für eine Photovoltaik (PV)-Anlage, mit einem Gehäuse mit mindestens einer Kammer und einem in der Kammer ausgebildeten Kühlluftkanal zum Durchführen von Umgebungsluft als Kühlluft für elektrische und/oder elektronischer Komponenten des Wechselrichters, die entlang des Kühlluftkanals angeordnet sind, wobei der Kühlluftkanal von einer Lufteinlassöffnung zu einer Luftauslassöffnung durch das Gehäuse geführt ist. Die Erfindung betrifft weiterhin ein Verfahren zum Kühlen eines Wechselrichters.

Wechselrichter werden - unter anderem in PV-Anlagen - zum Umwandeln eines Gleichstroms in einen zur Einspeisung in ein Energieversorgungsnetz konformen Wechselstrom verwendet. Insbesondere bei leistungsstärkeren Wechselrichtern, wie sie in PV- Freilandanlagen verwendet werden, weisen die Wechselrichter ein Gehäuse auf, das in Art eines Schaltschranks ausgebildet ist. Typischerweise wird Umgebungsluft als Kühlluft für wärmeerzeugende elektrische und/oder elektronische Komponenten des Wechselrichters verwendet. Zu diesem Zweck weist der Wechselrichter einen Kühlluftkanal auf, der durch das Gehäuse des Wechselrichters geführt ist. Der Anfang bzw. das Ende des Kühlluftkanals sind mit einer Lufteintrittsöffnung bzw. einer Luftauslassöffnung verbunden, die in einer Wandung des Gehäuses, beispielsweise der Rückwand oder einer Seitenwand, angebracht sind. Innerhalb des Gehäuses führt der Kühlluftkanal, gegebenenfalls gefaltet, an den zu kühlenden Komponenten vorbei, um deren im Betrieb produzierte Wärme mittels der Kühlluft abführen zu können. Durch eine gefaltete, beispielsweise mäanderförmige Ausführung des Kühlluftkanals kann dessen Länge im Gehäuse vergrößert werden und erreicht werden, dass der Kühlluftkanal an allen zu kühlenden Komponenten entlang führt. Auch der Kontakt der in dem Kühlkanal strömenden Kühlluft mit den zu kühlenden Komponenten lässt sich hierdurch optimieren und die Strömungsgeschwindigkeit der Kühlluft erhöhen. Beide Effekte führen zu einer im Mittel besseren Kühlwirkung eines gegebenen Volumenstromes der Kühlluft.

Dabei kann vorgesehen sein, das Gehäuse des Wechselrichters durch eine oder mehrere Trennwände in mehrere Kammern zu unterteilen, die hinsichtlich ihrer Abdichtung gegenüber der Umgebung verschiedenen Isolationsschutzklassen genügen können. Beispielsweise ist es bekannt, das Gehäuse des Wechselrichters in zwei Kammern zu unterteilen, wobei durch eine der Kammern der genannte Kühlluftkanal führt, wohingegen die weitere Kammer nach außen hin möglichst hermetisch abgeschlossen ist. Die abgeschlossene Kammer nimmt die empfindlicheren - in der Regel die elektronischen - Komponenten des Wechselrichters auf. Es kann vorgesehen sein, einen Umluft-Kühlluftstrom in der abgeschlossenen Kammer auszubilden, wobei ein Wärmetauscher vorgesehen ist, durch den der Umluft- Kühlluftstrom in der abgeschlossenen Kammer durch den Umgebungsluft-Kühlluftstrom, der durch den Kühlluftkanal geführt wird, gekühlt wird.

Bei einem Wechselrichter besteht ein Kühlbedarf insbesondere für die Leistungshalbleiter von Wechselrichterbrücken des Wechselrichters. Da insbesondere leistungsfähige Wechselrichter, wie die genannten Wechselrichter von PV-Freilandanlagen, in der Regel mehrphasig ausgebildet sind, wird eine Mehrzahl von Wechselrichterbrücken verwendet, die zusammengefasst auch als Stack bezeichnet werden. Weitere Komponenten, die einen erhöhten Kühlbedarf innerhalb des Wechselrichters haben, sind die Induktivitäten, auch Drosselspulen genannt, von Ausgangsstromfiltern und/oder Gleichspannungswandlern des Wechselrichters. Ausgangsstromfilter dienen der Glättung des Ausgangsstromsignals und werden daher auch als Sinusfilter bezeichnet. Gleichspannungswandler können den Wechselrichterbrücken vorgeschaltet sein, um eine an dem Wechselrichter anliegende Eingangsspannung heraufzusetzen (Hochsetzsteller) oder abzusenken (Tiefsetzsteller). Sie verwenden dabei Drosselspulen als Energiespeicher beim Transformieren der Spannung.

Im Kühlluftstrom sind die Drosselspulen dem Stack üblicherweise nachgeordnet, da der Stack einen höheren Kühlbedarf hat und Kühlluft auf einem geringeren Temperaturniveau benötigt. Es ergibt sich dabei jedoch häufig das Problem, dass die Kühlluftmenge nicht gleichermaßen optimal für den Stack und die Drosselspulen ist.

In der Druckschrift DE 41 06 684 A1 ist für den Automobilbereich ein Kühlluftkonzept zur Luftzufuhr zu mehreren Baueinheiten beschrieben. Es wird dabei die Möglichkeit angegeben, verschiedene Kühlluftströme abschnittsweise parallel zu führen, um den Luftbedarf der zu kühlenden Komponenten individuell durch Ventilklappen einstellen zu können. Weiter wird die Möglichkeit beschrieben, dass bei nacheinander in einem Kühlluftstrom liegenden Komponenten Luftauslässe zwischen den verschiedenen Komponenten angeordnet sind, über die ebenfalls der Kühlluftstrom für die einzelnen Komponenten individuell eingestellt werden kann. Das in der genannten Druckschrift beschriebene Kühlkonzept setzt jedoch einen aktiv durch einen Ventilator angetriebenen Kühlluftstrom voraus.

Weiterhin ist in der Druckschrift DE 20 2006 008 792 U1 ein Solarwechselrichter gezeigt, der einen gewinkelten Verlauf eines Kühlluftkanals zwischen einer Einlassöffnung und einer Auslassöffnung für Kühlluft aufweist.

In der Druckschrift CN 102111081 A ist ein PV-Wechselrichter offenbart, dessen Gehäuse zwei Kammern aufweist, die über eine Trennwand voneinander elektrisch und thermisch isoliert sind. In jeder der beiden Kammern wird ein Luftstrom über einen der jeweiligen Kammer zugeordneten Ventilator erzeugt.

Bei einem Wechselrichter in einer PV-Anlage variieren die übertragenen Leistungen je nach Einstrahlungsbedingungen der Sonneneinstrahlung erheblich. Aus Gründen der Energieeffizienz ist es dabei in einem Teillastbereich des Wechselrichters wünschenswert, den Kühlluftstrom nicht aktiv über einen Ventilator anzutreiben, sondern eine ausreichende Kühlung in dem Teillastbereich rein konvektionsgetrieben zu erzielen. Auf diese Weise wird eine ohnehin nur geringe PV-Leistung eines PV-Generators nicht zusätzlich noch durch einen Leistungsbedarf des Ventilators geschmälert.

Es ist daher eine Aufgabe der vorliegenden Erfindung, einen Wechselrichter bereitzustellen, bei dem entlang eines Kühlluftkanals angeordnete Komponenten sowohl bei Volllast, als auch im Teillastbereich optimal und energieeffizient durch Umgebungsluft gekühlt werden können. Es ist eine weitere Aufgabe, ein dafür geeignetes Verfahren zum Kühlen des Wechselrichters anzugeben.

Diese Aufgabe wird gelöst durch einen Wechselrichter bzw. ein Verfahren zum Kühlen eines Wechselrichters mit den Merkmalen des jeweiligen unabhängigen Anspruchs. Vorteilhafte Ausgestaltungen und Weiterbildungen sind in den abhängigen Ansprüchen angegeben.

Ein erfindungsgemäßer Wechselrichter der eingangs genannten Art, insbesondere für eine PV-Anlage, zeichnet sich dadurch aus, dass im Kühlluftkanal zwischen zweien der zu kühlenden Komponenten eine weitere Luftauslassöffnung vorgesehen ist, die oberhalb der Lufteinlassöffnung und oberhalb der Luftauslassöffnung angeordnet ist. Hierbei beinhaltet die Forderung, dass die weitere Luftauslassöffnung oberhalb der Lufteinlassöffnung und oberhalb der Luftauslassöffnung angeordnet ist, vorteilhafterweise, dass sich die gesamte Fläche der weiteren Luftauslassöffnung oberhalb der Lufteinlassöffnung und auch oberhalb der Luftauslassöffnung befindet. Es liegt jedoch auch im Rahmen der Erfindung, wenn nur ein Teil der gesamten Fläche der weiteren Luftauslassöffnung oberhalb der Lufteinlassöffnung und oberhalb der Luftauslassöffnung angeordnet ist. Der Begriff "oberhalb" bezieht sich hierbei auf eine Position, die der Wechselrichter laut Installationsanweisung oder anderen Betriebsempfehlungen im Betrieb einnehmen soll. Analoges gilt für den Begriff "unterhalb".

Im Normalbetrieb, z.B. im Volllastbetrieb des Wechselrichters, wird eine Bewegung der Kühlluft in dem Kühlluftkanal üblicherweise durch einen Ventilator hervorgerufen. Die weitere Luftauslassöffnung an der beschriebenen Stelle führt dazu, dass zwischen den beiden Luftauslassöffnungen ein geringerer Kühlluftstrom im Kühlluftkanal vorliegt. Dadurch werden die in diesem (hinteren) Abschnitt angeordneten Komponenten, die bevorzugt einen geringeren Kühlbedarf haben, weniger stark gekühlt, wohingegen in einem vorderen Abschnitt des Kühlluftkanals eine intensivere Kühlung vorherrscht. Der Druckverlust im Kühlluftkanal wird geringer und der Ventilator kann bei vorgegebener Luftströmung im vorderen Bereich des Kühlluftkanals kleiner ausgelegt werden bzw. energieeffizienter betrieben werden.
Im Teillastbetrieb des Wechselrichters kann der Kühlluftbedarf der Komponenten so gering sein, dass auf ein Betreiben des Ventilators verzichtet werden kann. Bei deaktiviertem Ventilator wird Kühlluft nur passiv durch Konvektionsströmung durch den Kühlluftkanal geführt. Die Anordnung der weiteren Luftauslassöffnung räumlich oberhalb der Lufteinlassöffnung in Verbindung mit in dem Kühlluftkanal angeordneten Wärmequellen führt zu einem konvektionsgetriebenen Kühlluftstrom in diesem Abschnitt des Kühlluftkanals in gleicher Richtung wie bei Betreiben des Ventilators. Die Kühlluft dringt durch die Lufteinlassöffnung ein und verlässt den Kühlluftkanal aufgewärmt durch den weiteren Luftauslass. Konvektion führt weiter dazu, dass bei deaktiviertem Ventilator Kühlluft in die Luftauslassöffnung eindringt, Wärme von den im hinteren Abschnitt des Kühlluftkanals angeordneten Komponenten aufnimmt und den Kühlluftkanal ebenfalls durch die weitere Luftauslassöffnung verlässt. In diesem Abschnitt des Kühlluftkanals stellt sich somit im Konvektionsbetrieb eine Luftströmung in umgekehrter Richtung ein als im Ventilations- bzw. Volllastbetrieb. Durch beide Abschnitte (vom Lufteinlass bis zum weiteren Luftauslass bzw. vom Luftauslass bis zum weiteren Luftauslass) wird somit "frische" Umgebungsluft geführt, die noch keine Abwärme eines andernfalls vorgelagerten Abschnitts des Kühlluftkanals aufgenommen hat. Auch im reinen Konvektionsbetrieb wird so eine ausreichende Kühlung aller Komponenten erzielt.

In einer vorteilhaften Ausgestaltung des Wechselrichters ist zwischen der Lufteinlassöffnung und der weiteren Luftauslassöffnung eine zu kühlende Komponente angeordnet, die den höchsten Kühlbedarf der Komponenten des Wechselrichters aufweist. Bevorzugt ist diese ein Kühlkörper mindestens einer Wechselrichterbrücke des Wechselrichters. Ebenfalls vorteilhaft ist zwischen der weiteren Luftauslassöffnung und der Luftauslassöffnung eine zu kühlende Komponente angeordnet, die einen geringeren Kühlbedarf aufweist. Bevorzugt ist dieses mindestens eine Drosselspule des Wechselrichters und besonders bevorzugt eine Drosselspule, die Teil eines Gleichspannungswandlers ist, der der Wechselrichterbrücke vorgeschaltet ist, oder die Teil eines Ausgangsstromfilters ist, der der Wechselrichterbrücke nachgeschaltet ist. Die in diesen Ausgestaltungen beschriebene Zuordnung der verschiedenen genannten Komponenten des Wechselrichters zu den unterschiedlichen Abschnitten des Kühlluftkanals führt aufgrund der unterschiedlichen Wärmeeinträge der Komponenten zu einem besonders effektiven Betrieb des Kühlsystems, sowohl im aktiven Betrieb mit Ventilator, als auch im passiven Betrieb ohne Ventilator.

Ein besonderer Vorteil ergibt sich zudem, wenn die mindestens eine Drosselspule einen Ferritkern aufweist. Eine derartige Drosselspule arbeitet bei einer gegenüber der Umgebung in gewissem Maße erhöhten Temperatur des Ferritkerns besonders verlustarm. Diese erhöhte Temperatur wird insbesondere dann erreicht, wenn die Drosselspule in dem Kühlluftkanal zwischen der weiteren Luftauslassöffnung und der Luftauslassöffnung angeordnet ist.

In einer weiteren vorteilhaften Ausgestaltung des Wechselrichters ist die weitere Luftauslassöffnung hinsichtlich ihrer wirksamen Luftaustrittsfläche verstellbar. Eine Verstellung der wirksamen Luftaustrittsfläche, die beispielsweise durch vor der weiteren Luftauslassöffnung angeordnete verstellbare Lamellen erreicht werden kann, ermöglicht es im aktiven, vom Ventilator unterstützten Kühlbetrieb die Kühlwirkung im hinteren Abschnitt des Kühlluftkanals einzustellen, ohne dass die Kühlwirkung im vorderen Abschnitt wesentlich beeinträchtigt wird.

In einer weiteren vorteilhaften Ausgestaltung des Wechselrichters ist der Kühlluftkanal gefaltet und insbesondere mäanderförmig ausgebildet. Zudem können die Luftauslassöffnung und die weitere Luftauslassöffnung an unterschiedlichen Seiten des Gehäuses angeordnet sein. Beide Ausgestaltungen ermöglichen eine Kühlluftführung innerhalb des Gehäuses des Wechselrichters, die flexibel an die Position der zu kühlenden Komponenten anpasst werden kann.

In einer weiteren vorteilhaften Ausgestaltung des Wechselrichters ist neben der Kammer eine weitere Kammer im Gehäuseinneren ausgebildet, wobei die Kammer und die weitere Kammer derart voneinander getrennt sind, dass ein Luftaustausch zwischen der Kammer und der weiteren Kammer verhindert ist, und wobei die Kammer und die weitere Kammer unterschiedlichen Isolationsschutzklassen genügen. Bevorzugt weist die Kammer, in der der Kühlluftkanal ausgebildet ist, eine niedrigere Isolationsschutzklasse auf als die weitere Kammer. Durch die Trennung des Gehäuseinneren des Wechselrichters in die beiden unterschiedlichen Kammern kann das beschriebene Kühlkonzept auch bei Wechselrichtern umgesetzt werden, bei denen für zumindest einige ihrer Komponenten eine höhere Isolationsschutzklasse verlangt ist. Die Isolationsschutzklassen können beispielsweise als sogenannte IP-Schutzklassen (international protection classes) definiert sein.

Bei einem erfindungsgemäßen Verfahren zum Kühlen eines Wechselrichters, insbesondere eines Wechselrichters einer PV-Anlage, weist der Wechselrichter ein Gehäuse mit mindestens einer Kammer auf, wobei in der Kammer ein Kühlluftkanal zum Durchführen von Umgebungsluft als Kühlluft für elektrische und/oder elektronische Komponenten des Wechselrichters ausgebildet ist, die entlang des Kühlluftkanals angeordnet sind, wobei der Kühlluftkanal von einer Lufteinlassöffnung zu einer Luftauslassöffnung durch das Gehäuse geführt ist, wobei im Kühlluftkanal zwischen zweien der zu kühlenden Komponenten eine weitere Luftauslassöffnung vorgesehen ist, und wobei der Wechselrichter einen im oder am Kühlluftkanal angeordneten Ventilator aufweist. Das Verfahren weist die folgenden Schritte auf: Der Wechselrichter wird bei aktiviertem Ventilator in einem Normalbetrieb betrieben, wodurch sich in der Kammer eine Luftströmung einstellt, bei der Luft durch die Lufteinlassöffnung in die Kammer eintritt und aus der Luftauslassöffnung und der weiteren Luftauslassöffnung aus der Kammer heraustritt. In einem weiteren Schritt wird der Wechselrichter bei deaktiviertem Ventilator in einem Teillastbetrieb betrieben, wodurch sich eine andere Luftströmung einstellt, bei der Luft durch die Lufteinlassöffnung und die Luftauslassöffnung in die Kammer eintritt und durch die weitere Luftauslassöffnung aus der Kammer heraustritt. Es ergeben sich die im Zusammenhang mit dem erfindungsgemäßen Wechselrichter beschriebenen Vorteile.

Die Erfindung wird nachfolgend anhand eines Ausführungsbeispiels mithilfe von Figuren näher erläutert. Es zeigen:
- Fig. 1: einen Wechselrichter mit Gehäuse in einer seitlichen Schnittansicht;
- Fig. 2: eine schematische, vereinfachte Darstellung des Wechselrichters der Fig. 1 und
- Fig. 3: eine perspektivische Außenansicht des Wechselrichters der Fig. 1.

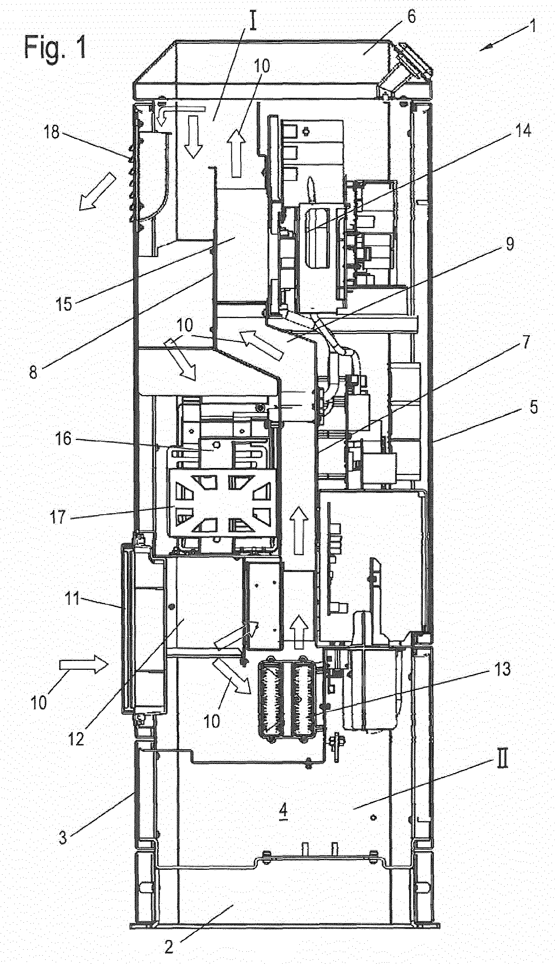

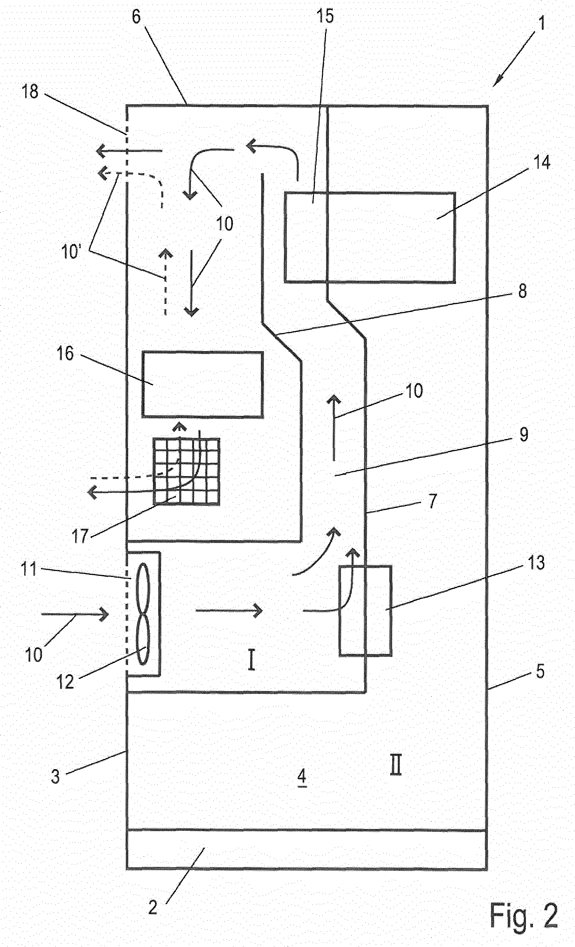

In den Fig. 1 und 2 ist ein Wechselrichter in einem Ausführungsbeispiel in einer seitlichen Schnittdarstellung wiedergegeben. Fig. 1 zeigt den Wechselrichter mit einem höheren Detailgrad, wohingegen Fig. 2 den Wechselrichter in einer schematischen, reduzierten Darstellung wiedergibt. Im Folgenden wird auf beide Figuren Bezug genommen.

Der Wechselrichter weist ein Gehäuse 1 auf, das in Art eines Schaltschranks, der auf einer Aufstellfläche aufgestellt wird, ausgebildet ist. Das Gehäuse 1 umfasst einen Sockel 2, eine Rückwand 3, Seitenwände 4, von denen in den Figuren nur eine Seitenwand 4 sichtbar ist, eine Tür 5, die gleichzeitig die Frontseite des Gehäuses 1 bildet, sowie einen Deckel 6. Innerhalb des Gehäuses 1 verläuft eine Trennwand 7, die das Gehäuseinnere in zwei voneinander getrennte Kammern teilt, eine Kammer I und eine weitere Kammer II. In der Kammer I ist ein Luftleitblech 8 so angeordnet, dass ausgehend von einer Lufteinlassöffnung 11 ein Kühlluftkanal 9 gebildet ist, der gefaltet durch die Kammer I verläuft. Eine durch den Kühlluftkanal 9 geführte Luftströmung 10 ist in den Figuren durch Strömungspfeile symbolisiert.

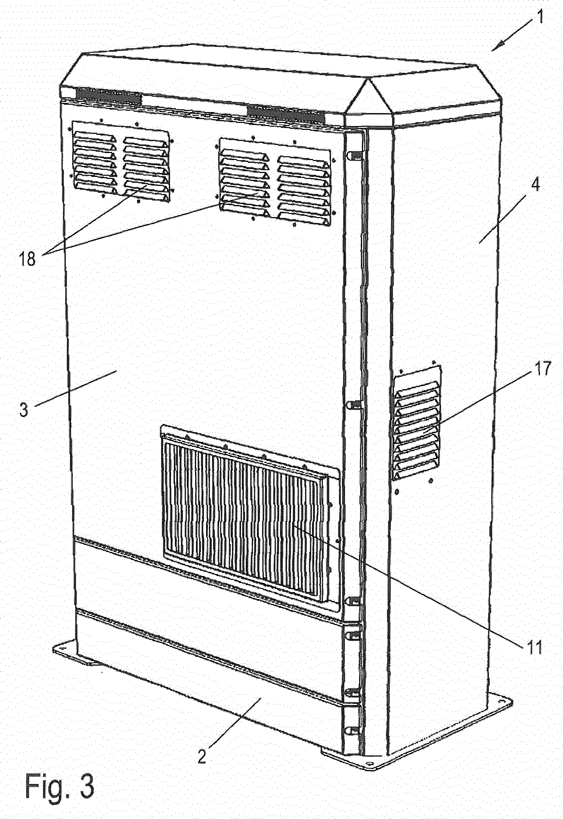

Die Lufteinlassöffnung 11 ist in die Rückwand 3 des Gehäuses 1 eingelassen und erstreckt sich über in etwa die halbe Breite der Rückwand 3. Dieses ist in Fig. 3 in einer perspektivischen Ansicht des Gehäuses 1 des Wechselrichters ersichtlich. Das Gehäuse 1 ist in der Fig. 3 in einer Ansicht von schräg hinten dargestellt. In dem dargestellten Ausführungsbeispiel erstreckt sich der Kühlluftkanal 9 über die gesamte Breite des Gehäuses 1, die Lufteinlassöffnung 11 ist jedoch nur über einen Teil dieser Breite ausgebildet. Es kann jedoch auch vorgesehen sein, eine sich im Wesentlichen über die gesamte Breite des Kühlluftkanals 9 und damit die gesamte Breite des Gehäuses 1 erstreckende Lufteinlassöffnung 11 vorzusehen. Eine sich über die gesamte Breite des Kühlluftkanals 9 und damit die gesamte Breite des Gehäuses 1 erstreckende Lufteinlassöffnung kann auch durch mehrere Lufteinlassöffnungen realisiert sein.

Im Hinblick auf die Höhe ist die Lufteinlassöffnung 11 in etwa in der oberen Hälfte des unteren Drittels des Gehäuses 1 angeordnet. Eine Anordnung in einem weiter unten liegenden Abschnitt des Gehäuses 1 kann unvorteilhaft sein, da bei einer tiefer liegenden Lufteinlassöffnung die Gefahr steigt, dass Staub oder anderer Schmutz vom Boden eingesaugt wird.

Die Lufteinlassöffnung 11 ist im dargestellten Ausführungsbeispiel mit einem Schmutzgitter versehen. Alternativ und/oder zusätzlich kann auch ein Luftlabyrinth der Lufteinlassöffnung 11 nachgeordnet sein. Hinter der Lufteinlassöffnung 11 ist ein Ventilator 12 angeordnet, der betrieben werden kann, um Luft durch die Lufteinlassöffnung 11 einzusaugen und durch den Kühlluftkanal 9 strömen zu lassen bzw. einen gegebenenfalls bestehenden Luftstrom zu verstärken. Eine Anordnung des Ventilators 12 an einer anderen Stelle des Kühlluftkanals 9 ist aber ebenfalls denkbar.

Innerhalb des Gehäuses 1 strömt die Luft zunächst in einen horizontalen Abschnitt des Kühlluftkanals 9, der in etwa in der Mitte des Gehäuses 1 in einen vertikalen Abschnitt übergeht. Am Ende des horizontalen Abschnitts befindet sich ein Luft-/Luftwärmetauscher 13, der von einem Teil der Strömung 10 im Kühlluftkanal 9 durchströmt und/oder um- oder überströmt wird. Dieser Luft-/Luftwärmetauscher 13 koppelt die weitere Kammer II thermisch an den Kühlluftkanal 9 der Kammer I an. Dargestellt ist in Fig. 1 der Fall, dass der Luft/Luftwärmetauscher 13 von Luft aus der Kammer II innenseitig durchströmt und von Luft innerhalb der Kammer I umströmt bzw. überströmt wird. Alternativ oder kumulativ dazu ist es jedoch möglich, dass der Luft/Luftwärmetauscher 13 innenseitig von Luft aus der Kammer I durchströmt wird und von Luft aus der Kammer II um- bzw. überströmt wird. Auch auf diese Weise lässt sich eine thermische Kopplung der weiteren Kammer II an den Kühlluftkanal 9 der Kammer I realisieren, wobei ein Luftaustausch zwischen Kammer I und Kammer II unterdrückt wird. Die weitere Kammer II ist gegenüber der Umgebung möglichst hermetisch abgedichtet und genügt damit einer höheren Isolationsschutzklasse, beispielsweise der Isolationsschutzklasse IP 54. In der weiteren Kammer II sind vor allem die elektronischen, empfindlicheren Komponenten des Wechselrichters aufgenommen, beispielsweise die im oberen Abschnitt der weiteren Kammer II angeordneten Wechselrichterbrücken 14, nachfolgend auch als Stack 14 bezeichnet. In der weiteren Kammer II ist ein in sich geschlossener Umluftkühlstrom ausgebildet, der Wärme von den zu kühlenden Komponenten aufnimmt und über den Luft-Luftwärmetauscher 13 an die Kühlluft im Kühlluftkanal 9 abgibt. Der in sich geschlossene Umluftkühlstrom in der weiteren Kammer II wird durch einen weiteren in der weiteren Kammer II lokalisierten Ventilator (in Fig. 1 und Fig. 2 nicht dargestellt) angetrieben. Alternativ dazu ist es jedoch auch möglich, dass der in sich geschlossene Umluftkühlstrom in der weiteren Kammer II rein konvektionsgetrieben ist und keinen weiteren Ventilator bedarf.

Die den Luft-/Luftwärmetauscher 13 umströmende Kühlluft und die an dem Luft-/Luftwärmetauscher 13 vorbeiströmende Kühlluft vereinigen sich im vertikalen Abschnitt des Kühlluftkanals 9 und werden an Kühlrippen eines Kühlkörpers 15 vorbeigeführt, über die Abwärme von Leistungselektronikkomponenten des Stacks 14 abgegeben wird. Die Kühlrippen ragen in den Kühlluftkanal 9 hinein, wobei auch hier die Trennung der Kammer I und der weiteren Kammer II aufrechtgehalten wird. Im Vollastbetrieb bei der Einspeisung besteht an dem Kühlkörper 15 der größte Kühlluftbedarf. Der Kühlluftstrom im Kühlluftkanal 9 wird hinsichtlich der durchströmenden Kühlluftmenge daher von dem Kühlluftbedarf des Kühlkörpers 15 bzw. der Leistungselektronik-Komponenten des Stack 14 bestimmt.

Das Luftleitblech 8 endet im oberen Bereich der Kammer I vor dem Deckel 6, wodurch der Kühlluftkanal 9 in diesem Bereich eine Kehre aufweist und die Kühlluft nach unten umgelenkt wird. Hierbei kann das Luftleitblech 8 sowohl oberhalb als auch etwas unterhalb der Kühlkörper 15 enden. Die Kühlluft strömt dann in einem in etwa auf zwei Drittel der Höhe des Gehäuses 1 liegenden Abschnitt des Gehäuses 1 an mehreren Drosselspulen 16 vorbei, um diese zu kühlen. Die Drosselspulen 16 sind einerseits Spulen des sogenannten Sinusfilters, der am Ausgang der Wechselrichterbrücke 14 der Signalformung des vom Wechselrichter abgegebenen und in ein Stromversorgungsnetz einzuspeisenden Stroms dient. Weiterhin sind in dem genannten Bereich Spulen eines Gleichspannungswandlers, der den Wechselrichterbrücken vorgeschaltet ist, angeordnet, wenn der Wechselrichter über einen derartigen Gleichspannungswandler verfügt. Der Gleichspannungswandler ist insbesondere ein Tiefsetzsteller oder ein Hochsetzsteller oder ein kombinierter Hoch-/Tiefsetzsteller.

Nach dem Passieren der Drosselspulen 16 wird die Kühlluft durch eine Luftauslassöffnung 17 in der Seitenwand 4 wieder an die Umgebung abgegeben. Die Luftauslassöffnung 17 ist im dargestellten Ausführungsbeispiel in einer Seitenwand 4 angeordnet. Es ist grundsätzlich jedoch auch möglich, die Luftauslassöffnung 17 in der Rückwand 3 des Gehäuses 1 anzuordnen. Des Weiteren ist es möglich, jeweils eine Luftauslassöffnung 17 in jeder der beiden Seitenwände 4 anzuordnen. Die seitliche Anordnung der Luftauslassöffnung 17 in der Seitenwand 4 ist gut in der perspektivischen Ansicht der Figur 3 zu sehen.

Wie bereits erwähnt, bestimmt im Vollastbetrieb der Kühlbedarf des Stacks 14 den durch den Kühlluftkanal 9 geleiteten Kühlluftstrom. Die Drosselspulen 16 haben üblicherweise einen geringeren Bedarf an Kühlluft als der Stack 14. Zudem sind die Drosselspulen 16 häufig mit einem Ferritkern versehen, um bei gleicher Baugröße eine höhere Induktivität erzielen zu können, als dieses mit Luftspulen möglich wäre. Dabei zeichnen sich die verwendeten Ferritmaterialien dadurch aus, dass im benutzen Frequenzbereich in einem charakteristischen Temperaturbereich eine besonders geringe Verlustleistung durch Ummagnetisierung vorliegt. Je nach Material kann die Temperatur, bei der die Verluste minimal sind, bei bis zu 100° Celsius liegen. Bei dieser Temperatur, oder zumindest bei einer Betriebstemperatur in Nähe dieser Temperatur, sind die Verluste in den Drosselspulen 16 am geringsten und der Wechselrichter kann besonders energieeffizient betrieben werden.

Werden die Drosselspulen 16 jedoch mit dem gesamten Luftstrom im Kühlluftkanal 9 gekühlt, der zur ausreichenden Kühlung des Stacks 14 benötigt wird, so wird die Temperatur der Drosselspulen 16 unterhalb des optimalen Temperaturbereichs liegen. Aus diesem Grund ist im Kühlluftkanal 9 zwischen dem Kühlkörper 15 des Stack 14 und den Drosselspulen 16 eine weitere Luftauslassöffnung 18 angeordnet, durch die ein Teil des Kühlluftstroms den Kühlluftkanal 9 verlässt, bevor der verbleibende Luftstrom die Drosselspulen 16 erreicht. Durch eine geeignete Einstellung des Strömungswiderstands der weiteren Luftauslassöffnung 18, z.B. über eine Variation einer wirksamen Luftaustrittsfläche der Luftauslassöffnung 18, kann das Verhältnis der Menge an Kühlluft, die den Kühlluftkanal 9 an der weiteren Luftauslassöffnung 18 verlässt, und der Menge an Kühlluft, die zur Kühlung der Drosselspulen 16 zur Verfügung steht, geeignet eingestellt werden. Gegebenenfalls kann ein aktiv im Betrieb verstellbares Verstellorgan in der weiteren Luftauslassöffnung 18 eingesetzt werden, durch das eine wirksame Luftaustrittsfläche veränderbar ist und somit die Luftmenge, die durch die weitere Luftauslassöffnung 18 abgegeben wird, einstellbar ist.

Die weitere Luftauslassöffnung 18 ist vorliegend in der Rückwand 3 angeordnet. Es versteht sich, dass eine Anordnung auch in einer oder mehrerer der Seitenwände 4 möglich ist. Um zu verhindern, dass Schmutz, Regenwasser und gegebenenfalls kleinere Tiere in die weitere Lufteinlassöffnung 18 eindringen können, ist diese vorteilhafterweise mit einem Schmutzgitter und auch Regenabweisern versehen. Die weitere Luftauslassöffnung 18 umfasst im dargestellten Ausführungsbeispiel zwei nebeneinanderliegende Öffnungen und ist unmittelbar unterhalb des Deckels 6 und damit an einem - beziehungsweise nahe bei einem - höchsten Punkt innerhalb des Kühlluftkanals 9 angeordnet.

Diese Anordnung der weiteren Luftauslassöffnung 18 oberhalb der Lufteinlassöffnung 11 und auch oberhalb der Luftauslassöffnung 17 erfüllt einen besonderen Zweck, zum Einen im Teillastbetrieb, also bei deaktiviertem Ventilator 12, zum Anderen jedoch auch im Normalbetrieb, also bei aktiviertem Ventilator 12, des Wechselrichters. Im Teillastbetrieb des Wechselrichters kann der Kühlluftbedarf der Komponenten, insbesondere auch des Stacks 14, so gering sein, dass auf ein Betreiben des Ventilators 12 verzichtet werden kann. Bei deaktiviertem Ventilator 12 wird Kühlluft nur passiv durch Konvektionsströmung durch den Kühlluftkanal 9 geführt. Die Anordnung der weiteren Luftauslassöffnung 18 oberhalb der Lufteinlassöffnung 11 in Verbindung mit in dem Kühlluftkanal angeordneten Wärmesenken, also beispielsweise dem Luft/Luft-Wärmetauscher 13 und/oder dem Kühlkörper 15, führt zu einem konvektionsgetriebenen Kühlluftstrom in diesem Abschnitt des Kühlluftkanals 9 in gleicher Richtung wie bei Betreiben des Ventilators 12. Die Kühlluft dringt durch die Lufteinlassöffnung 11 ein und verlässt nach Wärmeaufnahme am Luft-/Luftwärmetauscher 13 und an dem Kühlkörper 15 das Gehäuse 1 aufgewärmt durch den weiteren Luftauslass 18. Konvektion führt weiter dazu, dass bei deaktiviertem Ventilator 12 Kühlluft in die Luftauslassöffnung 17 eindringt, Wärme von den Drosselspulen 16 aufnimmt und den Kühlluftkanal 9 ebenfalls durch die weitere Luftauslassöffnung 18 verlässt. In diesem Abschnitt des Kühlluftkanals 9 stellt sich somit im Konvektionsbetrieb eine Luftströmung 10' in umgekehrter Richtung ein als im Ventilationsbetrieb bzw. bei aktiviertem Ventilator 12. Die Luftströmung 10' im Konvektionsbetrieb ist in der Fig. 2 durch gestrichelte Strömungspfeile symbolisiert. Durch die Anordnung der weiteren Luftauslassöffnung 18 oberhalb der Luftauslassöffnung 17 wird eine vertikale Orientierung des zwischen beiden Öffnungen liegenden Abschnitts des Kühlluftkanals 9 erzielt, die aufgrund des Kamineffekts zu einer ausgeprägteren Konvektion und damit zu einer vorteilhaften Kühlwirkung gegenüber einer horizontalen Orientierung dieses Abschnitts führt.

Im Normalbetrieb, z.B. im Volllastbetrieb, des Wechselrichters, also bei aktiviertem Ventilator 12, führt die weitere Luftauslassöffnung 18 an der beschriebenen Stelle dazu, dass der Druckverlust, welcher der Luftströmung 10 entgegenwirkt, insgesamt verringert wird. Somit kann der Ventilator 12 bei durch den Stack 14 vorgegebener Luftströmung 10 kleiner ausgelegt werden. Des Weiteren kann die Luftmenge zur Kühlung der Drosselspulen 16 in einem hinteren Bereich des Kühlluftkanals 9 auch bei großer Luftströmung 10 innerhalb eines vorderen Bereiches des Kühlluftkanals 9 derart dosiert werden, dass diese in einem Temperaturbereich betrieben werden, der durch eine besonders niedrige Verlustleistung gekennzeichnet ist. Eine übermäßige Kühlung der Drosselspulen 16 durch eine eventuell zu starke Luftströmung 10, die jedoch zum Abführen der Abwärme aus den Stacks 14 erforderlich ist, wird daher vermieden. Vorteilhafterweise sind zum Dosieren der Luftströmung 10 bzw. der Menge der Luftströmung 10, die bei aktiviertem Ventilator 12 durch die weitere Luftauslassöffnung 18 heraustritt, Mittel an dieser vorgesehen, um die effektive Austrittsfläche der weiteren Luftauslassöffnung 18 veränderbar zu gestalten. Derartige Mittel können beispielsweise durch verschiebbare Abblendbleche realisiert sein, die in den Figuren 1 bis 3 nicht explizit dargestellt sind. Das dargestellte Kühlkonzept führt daher in beiden Fällen, d.h. im aktiven Ventilationsbetrieb und im passiven Konvektionsbetrieb, zu einem ausreichenden Kühlluftstrom an allen zu kühlenden Komponenten.

### Bezugszeichenliste

- 1: Gehäuse
- 2: Sockel
- 3: Rückwand
- 4: Seitenwand
- 5: Tür
- 6: Deckel
- 7: Trennwand
- 8: Luftleitblech
- 9: Kühlluftkanal
- 10, 10': Luftströmung
- 11: Lufteinlassöffnung
- 12: Ventilator
- 13: Luft-/Luft-Wärmetauscher
- 14: Wechselrichterbrücke (Stack)
- 15: Kühlkörper
- 16: Drosselspule
- 17: Luftauslassöffnung
- 18: weitere Luftauslassöffnung

- I: Kammer
- II: weitere Kammer

## Patentansprüche

1. Wechselrichter, insbesondere für eine Photovoltaik-Anlage, mit einem Gehäuse (1) mit mindestens einer Kammer (I), einem in der Kammer (I) ausgebildeten Kühlluftkanal (9) zum Durchführen von Umgebungsluft als Kühlluft für elektrische und/oder elektronische Komponenten des Wechselrichters, die entlang des Kühlluftkanals (9) angeordnet sind, wobei der Kühlluftkanal (9) von einer Lufteinlassöffnung (11) zu einer Luftauslassöffnung (17) durch das Gehäuse (1) geführt ist und wobei der Wechselrichter einen im oder am Kühlluftkanal (9) angeordneten Ventilator (12) aufweist, **dadurch gekennzeichnet, dass**
im Kühlluftkanal (9) zwischen zweien der zu kühlenden Komponenten eine weitere Luftauslassöffnung (18) angeordnet ist, die oberhalb der Lufteinlassöffnung (11) und oberhalb der Luftauslassöffnung (17) angeordnet ist,
- wobei dann, wenn der Wechselrichter in einem Normalbetrieb bei aktiviertem Ventilator (12) betrieben wird, sich in der Kammer (I) eine Luftströmung einstellt, bei der Luft durch die Lufteinlassöffnung (11) in die Kammer (I) eintritt und aus der Luftauslassöffnung (17) und der weiteren Luftauslassöffnung (18) aus der Kammer (I) heraustritt, und
- wobei dann, wenn der Wechselrichter in einem Teillastbetrieb bei deaktiviertem Ventilator (12) betrieben wird, sich eine andere Luftströmung einstellt, bei der Luft durch die Lufteinlassöffnung (11) und die Luftauslassöffnung (17) in die Kammer (I) eintritt und durch die weitere Luftauslassöffnung (18) aus der Kammer (I) heraustritt.

2. Wechselrichter nach Anspruch 1, bei dem zwischen der Lufteinlassöffnung (11) und der weiteren Luftauslassöffnung (18) eine zu kühlende Komponente angeordnet ist, die den höchsten Kühlbedarf der Komponenten des Wechselrichters aufweist.

3. Wechselrichter nach Anspruch 2, bei dem die zwischen der Lufteinlassöffnung (11) und der weiteren Luftauslassöffnung (18) angeordnete Komponente ein Kühlkörper (15) mindestens einer Wechselrichterbrücke (14) des Wechselrichters ist.

4. Wechselrichter nach einem der Ansprüche 1 bis 3, bei dem zwischen der weiteren Luftauslassöffnung (18) und der Luftauslassöffnung (17) eine zu kühlende Komponente angeordnet ist, die einen geringeren Kühlbedarf aufweist.

5. Wechselrichter nach Anspruch 4, bei dem die zwischen der weiteren Luftauslassöffnung (18) und der Luftauslassöffnung (17) angeordnete Komponente mindestens eine Drosselspule (16) des Wechselrichters ist.

6. Wechselrichter nach Anspruch 5, bei dem die mindestens eine Drosselspule (16) Teil eines Gleichspannungswandlers ist, der einer Wechselrichterbrücke (14) vorgeschaltet ist.

7. Wechselrichter nach Anspruch 5 oder 6, bei dem die mindestens eine Drosselspule (16) Teil eines Ausgangsstromfilters ist, der der Wechselrichterbrücke (14) nachgeschaltet ist.

8. Wechselrichter nach einem der Ansprüche 5 bis 7, bei dem die mindestens eine Drosselspule (16) einen Ferritkern aufweist.

9. Wechselrichter nach einem der Ansprüche 1 bis 8, bei dem die weitere Luftauslassöffnung (18) hinsichtlich ihrer wirksamen Luftaustrittsfläche verstellbar ist.

10. Wechselrichter nach einem der Ansprüche 1 bis 9, bei dem der Kühlluftkanal (9) gefaltet ist und insbesondere mäanderförmig ausgebildet ist.

11. Wechselrichter nach einem der Ansprüche 1 bis 10, bei dem die Luftauslassöffnung (17) und die weitere Luftauslassöffnung (18) an unterschiedlichen Seiten des Gehäuses (1) angeordnet sind.

12. Wechselrichter nach einem der Ansprüche 1 bis 11, bei dem neben der Kammer (I) eine weitere Kammer (II) im Gehäuseinneren ausgebildet ist, wobei die Kammer (I) und die weitere Kammer (II) derart voneinander getrennt sind, dass ein Luftaustausch zwischen der Kammer (I) und der weiteren Kammer (II) verhindert ist, und wobei die Kammer (I) und die weitere Kammer (II) unterschiedlichen Isolationsschutzklassen genügen.

13. Wechselrichter nach Anspruch 12, bei dem die Kammer (I), in der der Kühlluftkanal (9) ausgebildet ist, eine niedrigere Isolationsschutzklasse aufweist als die weitere Kammer (II).

14. Verfahren zur Kühlung eines Wechselrichters, insbesondere eines Wechselrichters einer Photovoltaik-Anlage, wobei
- der Wechselrichter ein Gehäuse (1) mit mindestens einer Kammer (I) aufweist,
- in der Kammer (I) ein Kühlluftkanal (9) zum Durchführen von Umgebungsluft als Kühlluft für elektrische und/oder elektronische Komponenten des Wechselrichters ausgebildet ist, die entlang des Kühlluftkanals (9) angeordnet sind,
- der Kühlluftkanal (9) von einer Lufteinlassöffnung (11) zu einer Luftauslassöffnung (17) durch das Gehäuse (1) geführt ist,
- im Kühlluftkanal (9) zwischen zweien der zu kühlenden Komponenten eine weitere Luftauslassöffnung (18) vorgesehen ist, und
- der Wechselrichter einen im Kühlluftkanal angeordneten Ventilator (12) aufweist,
mit den folgenden Schritten:
- Betreiben des Wechselrichters in einem Normalbetrieb bei aktiviertem Ventilator (12), wodurch sich in der Kammer (I) eine Luftströmung (10) einstellt, bei der Luft durch die Lufteinlassöffnung (11) in die Kammer (I) eintritt und aus der Luftauslassöffnung (17) und der weiteren Luftauslassöffnung (18) aus der Kammer (I) heraustritt, und
- Betreiben des Wechselrichters in einem Teillastbetrieb bei deaktiviertem Ventilator (12), wodurch sich eine andere Luftströmung (10, 10') einstellt, bei der Luft durch die Lufteinlassöffnung (11) und die Luftauslassöffnung (17) in die Kammer (I) eintritt und durch die weitere Luftauslassöffnung (18) aus der Kammer (I) heraustritt.

## Claims

1. An inverter, in particular for a photovoltaic system, comprising a housing (1) with at least one chamber (I) and a cooling air channel (9) formed within the chamber (I) for guiding ambient air as cooling air for electrical and/or electronic components of the inverter disposed along the cooling air channel (9), wherein the cooling air channel (9) extends through the housing (1) from an air inlet (11) to an air outlet (17), and wherein the inverter comprises a fan arranged in or at the cooling air channel (9) **characterized in that**
a further air outlet (18) is arranged within the cooling air channel (9) between two of the components to be cooled, which further air outlet (18) is disposed above the air inlet (11) and the air outlet (17).

2. The inverter of claim 1, wherein a particular component to be cooled is disposed between the air inlet (11) and the further air outlet (18), which particular component comprises a maximum cooling requirement of the components of the inverter.

3. The inverter of claim 2, wherein the particular component disposed between the air inlet (11) and the further air outlet (18) is a cooling body (15) of at least one inverter bridge (14) of the inverter.

4. The inverter of one of the claims 1 to 3, wherein a further component to be cooled is disposed between the air outlet (17) and the further air outlet (18), which further component comprises a reduced cooling requirement.

5. The inverter of claim 4, wherein the further component disposed between the air outlet (17) and the further air outlet (18) is at least one inductor coil (16) of the inverter.

6. The inverter of claim 5, wherein the at least one inductor coil (16) is part of a DC converter connected upstream of the inverter bridge (14).

7. The inverter of claim 5 or 6, wherein the at least one inductor coil (16) is part of an output current filter connected downstream of the inverter bridge (14)

8. The inverter of one of the claims 5 to 7, wherein the at least one inductor coil (16) comprises a ferrite core.

9. The inverter of one of the claims 1 to 8, wherein the further air outlet (18) is adjustable with regard to its effective air outlet cross section.

10. The inverter of one of the claims 1 to 9, wherein the cooling air channel (9) is folded and is in particular formed as a meander.

11. The inverter of one of the claims 1 to 10, wherein the air outlet (17) and the further air outlet (18) are arranged at different sides of the housing (1).

12. The inverter of one of the claims 1 to 11, wherein a further chamber (II) is formed inside the housing (1) and beside the chamber (I), wherein the chamber (I) and the further chamber (II) are separated from each other such that an exchange of air between the chamber (I) and the further chamber (II) is prevented, and wherein the chamber (I) and the further chamber (II) meet the requirements of different protection classes.

13. The inverter of claim 12, wherein the chamber (I) comprising the cooling air channel (9) is assigned to a lower protection class than the further chamber (II).

14. A method of cooling an inverter, in particular an inverter of a photovoltaic system, wherein
- the inverter comprises a housing (1) with at least one chamber (I),
- a cooling air channel is formed within the chamber (I) for guiding ambient air as cooling air for electrical and/or electronic components of the inverter arranged along the cooling air channel (9),
- the cooling air channel (9) extends through the housing (1) from an air inlet (11) to an air outlet (17),
- a further air outlet (18) is provided between two of the components to be cooled, and
- the inverter comprises a fan (12) arranged in the cooling air channel,
the method comprising the steps:
- operating the inverter in a normal mode with activated fan (12), wherein an airflow (10) is generated within the chamber (I) such that air enters the chamber (I) at the air inlet (11) and exits the chamber (I) at the air outlet (17) and at the further air outlet (18), and
- operating the inverter in a partial load mode with deactivated fan (12), wherein a different airflow (10, 10') is generated such that air enters the chamber (I) at the air inlet (11) and at the air outlet (17) and exits the chamber (I) at the further air outlet (18).

## Revendications

1. Onduleur, en particulier pour une installation photovoltaïque, présentant un boîtier (1) doté d'au moins une chambre (I), un canal (9) d'air de refroidissement formé dans la chambre (I) pour permettre le passage d'air ambiant servant d'air de refroidissement pour des composants électriques et/ou électroniques de l'onduleur disposés le long du canal (9) d'air de refroidissement, le canal (9) d'air de refroidissement traversant le boîtier (1) depuis une ouverture (11) d'admission d'air vers une ouverture (17) de sortie d'air et l'onduleur présentant un ventilateur (12) disposé dans ou sur le canal (9) d'air de refroidissement,
**caractérisé en ce que**
une autre ouverture (18) de sortie d'air disposée au-dessus de l'ouverture (11) d'admission d'air et au-dessus de l'ouverture (17) de sortie d'air est prévue dans le canal (9) d'air de refroidissement entre deux des composants à refroidir,
lorsque l'onduleur est utilisé en fonctionnement normal avec le ventilateur (12) activé, un écoulement d'air s'établissant alors dans la chambre (I), écoulement d'air dans lequel l'air pénètre dans la chambre (I) par l'ouverture (11) d'admission d'air et sort de la chambre (I) par l'ouverture (17) de sortie d'air et l'autre ouverture (18) de sortie d'air et
lorsque l'onduleur est utilisé à charge partielle avec le ventilateur (12) désactivé, un autre écoulement d'air s'établissant alors, dans lequel l'air pénètre dans la chambre (I) par l'ouverture (11) d'admission d'air et l'ouverture (17) de sortie d'air et sort de la chambre (I) par l'autre ouverture (18) de sortie d'air.

2. Onduleur selon la revendication 1, dans lequel un composant à refroidir qui présente le plus grand besoin de refroidissement parmi les composants de l'onduleur est disposé entre l'ouverture (11) d'admission d'air et l'autre ouverture (18) de sortie d'air.

3. Onduleur selon la revendication 2, dans lequel le composant disposé entre l'ouverture (11) d'admission d'air et l'autre ouverture (18) de sortie d'air est un dissipateur thermique (15) d'au moins un pont onduleur (14) de l'onduleur.

4. Onduleur selon l'une des revendications 1 à 3, dans lequel un composant à refroidir qui présente un faible besoin de refroidissement est disposé entre l'autre ouverture (18) de sortie d'air et l'ouverture (17) de sortie d'air.

5. Onduleur selon la revendication 4, dans lequel le composant disposé entre l'autre ouverture (18) de sortie d'air et l'ouverture (17) de sortie d'air est au moins une bobine d'inductance (16) de l'onduleur.

6. Onduleur selon la revendication 5, dans lequel la ou les bobines d'inductance (16) font partie d'un convertisseur de tension continue raccordé en amont d'un pont onduleur (14).

7. Onduleur selon la revendication 5 ou 6, dans lequel la ou les bobines d'inductance (16) font partie d'un filtre de courant de sortie raccordé en aval du pont onduleur (14).

8. Onduleur selon l'une des revendications 5 à 7, dans lequel la ou les bobines d'inductance (16) présentent un noyau en ferrite.

9. Onduleur selon l'une des revendications 1 à 8, dans lequel la superficie active de sortie d'air de l'autre ouverture (18) de sortie d'air est ajustable.

10. Onduleur selon l'une des revendications 1 à 9, dans lequel le canal (9) d'air de refroidissement est replié et en particulier est réalisé en méandres.

11. Onduleur selon l'une des revendications 1 à 10, dans lequel l'ouverture (17) de sortie d'air et l'autre ouverture (18) de sortie d'air sont disposées sur des côtés différents du boîtier (1).

12. Onduleur selon l'une des revendications 1 à 11, dans lequel une autre chambre (II) est formée en plus de la chambre (I) à l'intérieur du boîtier, la chambre (I) et l'autre chambre (II) étant séparées l'une de l'autre de manière à empêcher un échange d'air entre la chambre (I) et l'autre chambre (II), la chambre (I) et l'autre chambre (II) respectant des classes différentes de protection isolante.

13. Onduleur selon la revendication 12, dans lequel la chambre (I) dans laquelle est formé le canal (9) d'air de refroidissement est d'une classe de protection isolante plus basse que l'autre chambre (II).

14. Procédé de refroidissement d'un onduleur, en particulier d'un onduleur d'une installation photovoltaïque, dans lequel :
l'onduleur présente un boîtier (1) doté d'au moins une chambre (I),
dans la chambre (I) est formé un canal (9) d'air de refroidissement qui permet le passage d'air ambiant servant d'air de refroidissement pour des composants électriques et/ou électroniques de l'onduleur disposés le long du canal (9) d'air de refroidissement,
le canal (9) d'air de refroidissement traverse le boîtier (1) depuis une ouverture (11) d'admission d'air vers une ouverture (17) de sortie d'air,
une autre ouverture (18) de sortie d'air est prévue dans le canal (9) d'air de refroidissement entre deux des composants à refroidir et
l'onduleur présente un ventilateur (12) disposé dans le canal d'air de refroidissement,
le procédé présentant les étapes suivantes :
utilisation de l'onduleur en fonctionnement normal avec le ventilateur (12) activé, par laquelle il s'établit dans la chambre (I) un écoulement d'air (10) dans lequel l'air pénètre dans la chambre (I) par l'ouverture (11) d'admission d'air et sort de la chambre (I) par l'ouverture (17) de sortie d'air et l'autre ouverture (18) de sortie d'air et
utilisation de l'onduleur à charge partielle avec le ventilateur (12) désactivé, par laquelle il s'établit un autre écoulement d'air (10, 10') dans lequel l'air pénètre dans la chambre (I) par l'ouverture (11) d'admission d'air et l'ouverture (17) de sortie d'air et sort de la chambre (I) par l'autre ouverture (18) de sortie d'air.
